# EUROPÄISCHE PATENTSCHRIFT

(11) **EP 2 149 285 B1**
(45) Veröffentlichungstag und Bekanntmachung des Hinweises auf die Patenterteilung: **14.01.2015**
(21) Anmeldenummer: 08758659.0
(22) Anmeldetag: 21.05.2008
(51) Int. Cl.: H05H 1/24

(54) **VERFAHREN UND VORRICHTUNG ZUR KOMBINIERTEN BEHANDLUNG EINER OBERFLÄCHE MIT EINEM PLASMA UND MIT ELEKTROMAGNETISCHER STRAHLUNG**
METHOD AND DEVICE FOR THE COMBINED TREATMENT OF A SURFACE WITH PLASMA AND WITH ELECTROMAGNETIC RADIATION
PROCÉDÉ ET DISPOSITIF POUR TRAITER DE MANIÈRE COMBINÉE UNE SURFACE COMPRENANT UN PLASMA ET UN RAYONNEMENT ÉLECTROMAGNÉTIQUE

(30) Priorität: 22.05.2007 DE 102007024027
(43) Veröffentlichungstag der Anmeldung: 03.02.2010
(73) Patentinhaber: Fachhochschule Hildesheim / Holzminden / Göttingen, 31134 Hildesheim (DE)
(72) Erfinder: VIÖL, Wolfgang, 37139 Adelebsen (DE); MERTENS, Nina, 37081 Göttingen (DE); HELMKE, Andreas, 37574 Einbeck (DE)
(74) Vertreter: REHBERG HÜPPE + PARTNER
(86) Internationale Anmeldenummer: PCT/EP2008/004052
(87) Internationale Veröffentlichungsnummer: WO 2008/141809

(56) Entgegenhaltungen:
- WO-A-96/08211
- DE-B3-102006 057 017
- US-A- 5 800 617
- US-A1- 2005 167 260
- CHOI K-S ET AL: "PLASMA ETCHING OF COPPER FILMS USING ULTRA VIOLET RADIATION" EXTENDED ABSTRACTS OF THE INTERNATIONAL CONFERENCE ON SOLIDSTATE DEVICES AND MATERIALS, JAPAN SOCIETY OF APPLIED PHYSICS. TOKYO, JA, 1. September 1997 (1997-09-01), Seite 300/301, XP000728124

## Beschreibung

### TECHNISCHES GEBIET DER ERFINDUNG

Die Erfindung bezieht sich auf ein Verfahren zur Behandlung einer Oberfläche und/oder von einer Oberfläche nahen Bereichen eines Körpers mit den Merkmalen des Oberbegriffs des Patentanspruchs 1 sowie eine Vorrichtung für eine solche Behandlung mit den Merkmalen des Oberbegriffs des Patentanspruchs 8.

Dabei sind mit den "einer Oberfläche nahen Bereichen eines Körpers" insbesondere geschlossene oder poröse Deckschichten oder -lagen eines Körpers, beispielsweise in Form von Beschichtungen eines Körpers gemeint.

### STAND DER TECHNIK

Die Behandlung von Oberflächen mittels einer Gasentladung ist bekannt. Dabei ist sowohl die Behandlung von "toten" Oberflächen, wie beispielsweise Werkstücken als auch von biologischen Materialien bekannt. Mit dem in dieser Beschreibung verwendeten Begriff Körper sollen sowohl solche Werkstücke als auch solche biologischen Materialien abgedeckt sein.

Ein Verfahren zur Behandlung von biologischen Materialien mittels einer Gasentladung geht aus der WO 2004/10810 A1 hervor. Hier wird eine an ihrer Spitze mit einer dielektrischen Abschirmung versehene stabförmige Festkörperelektrode mit Abstand der Spitze gegenüber der zu behandelnden Oberfläche angeordnet, und dann wird mit einem Spannungsgenerator eine elektrische Spannung in Form einer Wechselhochspannung aus einzelnen bipolaren Pulsen oder Pulsgruppen an die Festkörperelektrode angelegt, um die durch das Dielektrikum behinderte Gasentladung zwischen der Festkörperelektrode und der Oberfläche hervorzurufen. Durch die Gasentladung werden beispielsweise Bakterien und andere Keime an der Oberfläche abgetötet.

Bei einer Gasentladung entsteht ein Plasma, das reaktive Spezies, wie beispielsweise freie Elektronen und Radikale, aber auch Photonen, d. h. Licht aufweist, welche auf die mittels der Gasentladung behandelte Oberfläche einwirken. So soll beispielsweise gemäß der DE 195 03718 A1 die aus einer dielektrisch behinderten Ladung austretende UV-Strahlung zur Reinigung einer Oberfläche in einer Vakuumkammer während der Evakuierungsphase der Vakuumkammer genutzt werden.

In der Medizin ist die Verwendung von Licht, beispielsweise mit der spektralen Verteilung des sichtbaren Sonnenlichts, aber auch von Infrarotlicht zum Beispiel zur Förderung der Wundheilung grundsätzlich bekannt.

Das Härten von Farben, Lacken und anderen polymeren Oberflächenbeschichtungen mit Licht, beispielsweise UV-Licht ist ebenfalls grundsätzlich bekannt.

Aus der WO 03/093526 A2 ist eine Vorrichtung zur Behandlung der äußeren Oberfläche eines Metalldrahts mittels einer dielektrisch behinderten Gasentladung bekannt, die eine rohrförmige Festkörperelektrode mit einer an der Innenseite des Rohrs angeordneten dielektrischen Abschirmung aufweist. Der Draht läuft auf der Rohrachse durch diese Festkörperelektrode hindurch. Dabei sind die Festkörperelektrode und deren dielektrische Abschirmung transparent ausgebildet, indem die Festkörperelektrode in Form eines Drahts mit untereinander beabstandeten Windungen auf das rohrförmige Dielektrikum aus Glas aufgewickelt ist, um die Gasentladung zwischen dem Draht und der Festkörperelektrode im Inneren des Rohrs überwachen zu können.

Transparente Festkörperelektroden in Form von flächigen Metallgittern sind ebenfalls grundsätzlich bekannt.

Eine Behandlung einer Oberfläche eines Körpers, bei der eine Spannung an eine mit Abstand zu der Oberfläche angeordnete Festkörperelektrode angelegt wird, um eine Gasentladung zwischen der Oberfläche und der Festkörperelektrode hervorzurufen, und wobei im Bereich der Gasentladung eine elektromagnetische Strahlung von einer außerhalb der Gasentladung angeordneten und autonom steuerbaren Strahlungsquelle auf die Oberfläche gerichtet wird, ist aus der EP 1 454 705 A1 bekannt. Ziel ist hier die thermische Bearbeitung eines Werkstücks mit einem Laserstrahl. Das Werkstück umfasst einen Körper aus einem Metall, insbesondere aus Aluminium, und eine Oberflächenbeschichtung, wie beispielsweise eine Oxidschicht. Die Oberflächenbeschichtung wird vor und/oder während der Laserbearbeitung mit Hilfe eines Plasmas abgetragen. Auf diese Weise wird die Oberfläche des Werkstücks gereinigt und vorbehandelt. Das Plasma wird durch eine Gasentladung zwischen dem Werkstück und einer Wolfram-Elektrode, zwischen denen einen Wechselspannung anliegt, hervorgerufen, während ein inertes Prozessgas, wie Argon, Helium oder eine Mischung der beiden zugeführt wird.

Aus der DE 102 57 344 A1 ist ein Verfahren zur Konservierung von Metalloberflächen bekannt, bei dem eine dielektrisch behinderte Entladung zwischen einer planaren Festkörperelektrode und der zu behandelnden Metalloberfläche hervorgerufen wird. Dabei wird die auf ihrer der Metalloberfläche zugekehrten Seite mit einem Dielektrikum belegte Festkörperelektrode parallel zu der jeweiligen Metalloberfläche ausgerichtet.

Aus der DE 43 02 465 C1 ist eine Vorrichtung zum Erzeugen einer dielektrisch behinderten Entladung bekannt, bei der in einem Entladungsraum zwischen zwei Festkörperelektroden eine Hauptentladung hervorgerufen wird, die als Plasmaelektrode für eine dielektrisch behinderte Entladung über einer zu behandelnden Oberfläche dient. Die dielektrische Behinderung dieser Entladung wird durch ein Dielektrikum bewirkt, das eine parallel zu der Oberfläche ausgerichtete Wandung des Entladungsraums ausbildet. Dieses Dielektrikum ist transparent und lässt so Strahlung aus der Hauptentladung auf die Oberfläche hin austreten. Die der Oberfläche abgewandte Wandung des Entladungsraums ist dabei strahlungssperrend oder -reflektierend ausgebildet. Eine Wechselspannung, die beide Entladungen hervorruft, liegt zwischen einer der den Entladungsraum begrenzenden Festkörperelektroden und der Oberfläche an.

Während die beiden Festkörperelektroden gemäß der DE 43 02 465 C1 senkrecht zu der Oberfläche ausgerichtet sind und direkt an den Entladungsraum angrenzen, sind bei einem aus der EP 1 337 281 B1 bekannten Aufbau zwei Elektroden vorgesehen, die planparallel zueinander angeordnet sind, wobei die eine auf der einer zu behandelnden Oberfläche abgekehrten Rückseite eines Objekts liegt, während die andere auf der dieser Oberfläche abgekehrten Rückseite eines durch ein dielektrisches und transparentes Gehäuse begrenzten Entladungsraums liegt. Durch eine Wechselspannung zwischen diesen Elektroden wird in dem Entladungsraum eine Hauptentladung erzeugt, die als Plasmazwischenelektrode für eine dielektrisch behinderte Entladung zwischen dem Gehäuse des Entladungsraums und der Oberfläche dient. Die andere Festkörperelektrode und das dielektrische Gehäuse des Entladungsraums sind entsprechend parallel zu der zu behandelnden Oberfläche des Objekts angeordnet.

Aus Choi K-S et al: "PLASMA ETCHING OF COPPER FILMS USING ULTRA VIOLET RADIATION" EXTENDED ABSTRACTS OF THE INTERNATIONAL CONFERENCE ON SOLIDSTATE DEVICES AND MATERIAL; JAPAN SOCIETY OF APPLIED PHYSICS: TOKYO; JA; 1. September 1997 (1997-09-01), Seite 2300, 301, XP0028124 ist ein Verfahren zum Plasmaätzen von Kupferfilmen unter Verwendung von ultravioletter Strahlung bekannt. Dabei wird die ultraviolette Strahlung durch ein Quarzfenster eines evakuierten Raums auf das jeweilige Substrat gerichtet. Außen an dem Quarzfenster ist eine Hochfrequenzantenne mit einer Windung angeordnet, um eine Radiofrequenzwelle von 13,56 MHz anzuregen. Hierdurch wird ein induktiv gekoppeltes Plasma (inductively coupled plasma = ICP) über dem Substrat in einer Mischung aus Cl₂/N₂ oder Cl₂/Ar als Ätzgas gezündet. Beim Plasmaätzen liegt an dem Substrat zudem eine Wechselspannung an.

In Choi K-S et al wird als Literaturquelle zum induktiv gekoppelten Plasma (ICP) auf J. B. Carter et al: "Transformer coupled plasma etch technology for the fabrication of subhalf micron structures"; J.Vac.Sci.Technol. A11 (4), Jul/Aug 1993, Seiten 1301-6, verwiesen. J. B. Carter et al beschreiben einen Reaktor für ein hier als transformatorisch gekoppeltes Plasma bezeichnetes ICP, bei dem eine Entladung hoher Dichte mit 13,56 MHz Radiofrequenzleistung durch induktive Kopplung einer ebenen Quellspule in das Gas in einer Prozesskammer erzeugt wird. Das induktive Koppeln erfolgt durch ein dielektrisches Fenster, das die Oberseite der Prozesskammer ausbildet. Die Entladung wird direkt oberhalb eines zu behandelnden Wafers erzeugt. Eine kleine Gleichvorspannung wird an der Waferoberfläche durch eine zweite 13,56 MHz Radiofrequenzleistungsquelle erzeugt, die an die untere Elektrode angeschlossen ist.

Aus der US-A-5,800,617 sind ein Verfahren zur chemischen Dampfablagerung mit den Merkmalen des Oberbegriffs des Patentanspruchs 1 und eine entsprechende Vorrichtung mit den Merkmalen des Oberbegriffs des Patentanspruchs 8 bekannt. Dabei werden reaktive Spezies und ausreichend primäre Energie einer Oberfläche zugeführt, um die Spezies dazu zu bringen, sich auf der Oberfläche abzulagern. Zusätzliche Energie wird vorzugsweise in Form optischer Energie zugeführt. Dabei können Mittel zur Bereitstellung der primären Energie einen Radiofrequenzgenerator umfassen, der ein Radiofrequenzfeld zwischen einem die Oberfläche aufweisenden Wafer und einer Anode erzeugt. Diese Anode kann zugleich als Prozessgasverteiler dienen. Durch Schlitze in der Anode kann dabei nicht nur das Prozessgas austreten, sondern auch Licht von Lichtquellen zur Bereitstellung der sekundären Energie.

### AUFGABE DER ERFINDUNG

Der Erfindung liegt die Aufgabe zugrunde, ein Verfahren mit den Merkmalen des Oberbegriffs des Patentanspruchs 1 und eine Vorrichtung mit den Merkmalen des Oberbegriffs des Patentanspruchs 8 aufzuzeigen, mit denen eine flächige kontrollierte Behandlung von biologischen Oberflächen und Oberflächenbeschichtungen sowohl mit einem durch eine Gasentladung bereitstellbaren Plasma als auch mit elektromagnetischer Strahlung möglich ist.

### LÖSUNG

Die Aufgabe der Erfindung wird durch ein Verfahren mit den Merkmalen des Patentanspruchs 1 und eine Vorrichtung mit den Merkmalen des Patentanspruchs 8 gelöst. Bevorzugte Ausführungsformen des neuen Verfahrens sind in den abhängigen Patentansprüchen 2 bis 6 beschrieben. Patentanspruch 7 betrifft eine Anwendung des neuen Verfahrens zur Aushärtung von Farben, Lacken und anderen polymeren Oberflächenbeschichtungen. Die abhängigen Patentansprüche 9 bis 13 betreffen bevorzugte Ausführungsformen der neuen Vorrichtung. Patentanspruch 14 ist auf einer Aushärtevorrichtung für Farben, Lacken und andere polymere Oberflächenbeschichtungen gerichtet, während Patentanspruch 15 auf eine Haut- oder Wundtherapievorrichtung gerichtet ist.

### BESCHREIBUNG DER ERFINDUNG

Bei dem neuen Verfahren wird die Festkörperelektrode, bei der es sich um eine planare Festkörperelektrode handelt, parallel zu der zu behandelnden Oberfläche ausgerichtet. Entsprechend wird durch das Anlegen der Spannung an die Festkörperelektrode eine flächige Gasentladung über der zu behandelnden Oberfläche hervorgerufen. Gleichzeitig zu der Behandlung mit dem durch die Gasentladung erzeugten Plasma bzw. den darin enthaltenen reaktiven Spezies wird die zu behandelnde Oberfläche flächig mit elektromagnetischer Strahlung behandelt, die von der außerhalb der Gasentladung angeordneten, d. h. externen und daher autonom, d. h. unabhängig von der Gasentladung steuerbaren Strahlungsquelle durch die zu diesem Zweck transparent für elektromagnetische Strahlung ausgebildete Festkörperelektrode hindurch auf die Oberfläche gerichtet wird. Die Oberfläche wird auf diese Weise über eine Fläche von mehreren Quadratzentimetern, vorzugsweise mehreren 10 cm² und am meisten bevorzugt mehr als 100 cm² gleichzeitig sowohl mit dem durch die Gasentladung erzeugten Plasma als auch durch die elektromagnetische Strahlung behandelt. Dabei treten erhebliche Synergieeffekte auf, d. h. Reaktionen, die nur durch das Zusammentreffen des Plasmas mit der elektromagnetischen Strahlung ausgelöst werden können. Gleichzeitig kann durch die flächige Behandlung der Oberfläche mit dem neuen Verfahren sowohl eine über die Fläche gleichmäßige Behandlung als auch eine sanfte Behandlung sicher gestellt werden. Mit einer kleineren Festkörperelektrode müsste für denselben Gesamtenergieübertrag auf die Oberfläche eine viel höhere Energiedichte gewählt werden, als dies bei der planaren Festkörperelektrode mit erheblicher Flächenerstreckung erforderlich ist.

Die Gasentladung wird bei dem neuen Verfahren durch ein vor der Festkörperelektrode angeordnetes, ebenfalls planares und für elektromagnetische Strahlung transparentes Dielektrikum dielektrisch behindert. Wenn gleichzeitig die Spannung aus untereinander beabstandeten Spannungspulsen oder Spannungsgruppen ausgebildet wird, die vorzugsweise wechselnde Polaritäten aufweisen, kann die Gasentladung auch bei Atmosphärendruck mit geringem Aufwand, d. h. sowohl mit geringem apparativem Aufwand als auch mit geringer elektrischer Leistung sowohl gezündet als auch soweit aufrecht erhalten werden, dass das gewünschte Plasma bzw. die in ihm enthaltenen reaktiven Spezies andauernd vorliegen.

Für das neue Verfahren ist es nicht zwingend erforderlich, dass die zu behandelnde Oberfläche elektrisch kontaktiert wird. Die zu behandelnde Oberfläche muss nicht einmal elektrisch leitfähig sein. Bei dem neuen Verfahren wird primär die elektrische Kapazität der zu behandelnden Oberfläche ausgenutzt, die auch bei nicht elektrisch leitenden Oberflächen vorhanden ist, um die Gasentladung zwischen der Festkörperelektrode und der Oberfläche hervorzurufen.

Die elektromagnetische Strahlung, die bei dem neuen Verfahren neben dem Plasma auf die zu behandelnde Oberfläche einwirkt, kann aus infrarotem, sichtbarem oder ultraviolettem Licht ausgebildet sein. Dabei kann auch Licht mehrerer Wellenlängen gleichzeitig eingesetzt werden. Insbesondere kann eine spektral breitbandige Strahlung verwendet werden. Die elektromagnetische Strahlung hängt dabei stark von der gewünschten Wirkung der Behandlung auf die Oberfläche ab. So kann es sich bei ihr auch um kohärente und monochromatische Laserstrahlung handeln. Häufig ist die Kohärenz der elektromagnetischen Strahlung aber nicht erforderlich, um die gewünschten Wirkungen des neuen Verfahrens zu erzielen. Hingegen kann monochromatisches oder spektral schmalbandiges Licht von Interesse sein, wenn mit dem Licht bestimmte energetische Übergänge angeregt oder chemische Reaktionen an der Oberfläche ausgelöst werden sollen. Dies kann beispielsweise beim Aushärten von Farben, Lacken und anderen polymeren Oberflächenbeschichtungen, aber auch beim Abtöten bestimmter Keime der Fall sein. Durch die außerhalb der Gasentladung angeordnete, d. h. externe und autonom steuerbare Strahlungsquelle bestehen große Freiheiten bezüglich der Auswahl des Spektrums und der Intensität bzw. Intensitätsverteilung der elektromagnetischen Strahlung. Diese Freiheiten sind nutzbar, um die elektromagnetische Strahlung in jeder Hinsicht für das angestrebte Ziel der Behandlung zu optimieren.

Wie bereits bei der Beschreibung des neuen Verfahrens anklang, weist die neue Vorrichtung eine planare und für elektromagnetische Strahlung transparente Festkörperelektrode und eine hinter der Festkörperelektrode angeordnete Strahlungsquelle auf, um die elektromagnetische Strahlung durch die transparente Festkörperelektrode hindurch auf die Oberfläche zu richten, während zwischen der Oberfläche und der Festkörperelektrode das durch Gasentladung erzeugte Plasma vorliegt.

Auch bezüglich der bevorzugten Ausführungsformen der neuen Vorrichtung kann im Wesentlichen auf die Ausführung zu dem neuen Verfahren verwiesen werden.

Die transparente Festkörperelektrode kann eine ITO-(Indium-Zinn-Oxyd-)Schicht auf einem Quarzsubstrat sein, das zugleich als dielektrische Abschirmung der Festkörperelektrode dient. Es ist jedoch bevorzugt, dass die planare und für elektromagnetische Strahlung transparente Festkörperelektrode ein als solches nicht transparentes flächiges Metallgitter aufweist, weil eine derartige Festkörperelektrode kostengünstiger herstellbar ist, eine größere Standzeit erwarten lässt und ein von der Wellenlänge der elektromagnetischen Strahlung nur wenig abhängiges Transmissionsverhalten zeigt. Bei einem flächigen Metallgitter für die Festkörperelektrode können die Maschen vergleichsweise groß sein. Sie weisen typischer Weise eine Fläche von jeweils mindestens 0,2 mm² auf. Vorzugsweise beträgt ihre Fläche jeweils mehr als 1 mm² und am meisten bevorzugt jeweils mehr als 5 mm². Die Fläche kann jeweils auch größer als 10 oder auch 100 mm² sein. Bei der ihrerseits noch um ein Vielfaches größeren Festkörperelektrode wird dennoch eine flächige Gasentladung und damit ein flächiges Plasma zwischen ihr und der zu behandelnden Oberfläche hervorgerufen. Die Unregelmäßigkeiten des elektrischen Felds über der Fläche der Festkörperelektrode, die auf die Maschen, d. h. Löcher der Festkörperelektrode zurückgehen, wirken sich dabei sogar in dem Sinne positiv aus, als dass die Spitzen des elektrischen Felds vor den "Stäben" des Metallgitters das Zünden der Gasentladung erleichtern. Dies gilt insbesondere dann, wenn die Flächenbelegung des die transparente Festkörperelektrode ausbildenden flächigen Metallgitters vergleichsweise gering ist. Im Regelfall beträgt sie weniger als 25 %, vorzugsweise weniger als 10 % und am meisten bevorzugt weniger als 5 %. Dabei ist die Form der Maschen, womit hier die Löcher des Metallgitters bezeichnet sind, zwar weniger entscheidend. Durchaus günstig sind aber quadratische oder rautenförmige Maschen, weil diese im Vergleich zu beispielsweise kreisrunden Löchern eine tendenziell niedrigere Flächenbelegung des als solches nicht transparent flächigen Metallgitters der für elektromagnetische Strahlung transparenten Festkörperelektrode erlauben. Bei einem solchen Metallgitter tritt die elektromagnetische Strahlung normalerweise ausschließlich durch die Maschen bzw. Löcher hindurch. Der auf die Gitterstäbe auftreffende Teil der elektromagnetischen Strahlung wird hingegen reflektiert oder absorbiert. Bei einer geringen Flächenbelegung ist dieser Anteil aber auch entsprechend gering.

Die neue Vorrichtung kann als Aushärtevorrichtung für Farben, Lacke und andere polymere Oberflächenbeschichtungen verwendet werden. Daneben kann sie mit Erfolg auch als Hautoder Wundtherapievorrichtung eingesetzt werden. Dabei ist davon auszugehen, dass das Plasma, das durch die Gasentladung über der Oberfläche erzeugt wird, Bakterien und andere Keime an der Oberfläche abtötet, während die elektromagnetische Strahlung die gesunden Zellen in den oberflächennahen Bereichen der behandelten Haut oder Wunde zu Wachstum stimuliert.

Der Schutzumfang der Erfindung ist in den Ansprüchen definiert.

### KURZBESCHREIBUNG DER FIGUREN

Die Erfindung wird im Folgenden anhand eines Ausführungsbeispiels näher erläutert und beschrieben.

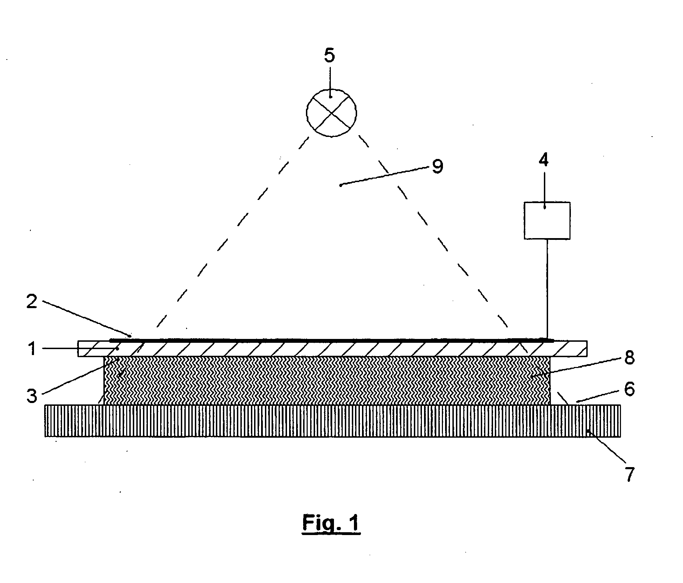

- **Fig. 1**: zeigt den Aufbau und die Verwendung der neuen Vorrichtung in einem Schnitt senkrecht durch deren Festkörperelektrode und die eine mit ihr zu behandelnde Oberfläche.

### FIGURENBESCHREIBUNG

Die in **Fig. 1** dargestellte Vorrichtung dient zur Realisierung einer dielektrisch behinderten Entladung, die auch als Barriereentladung bezeichnet wird. Bei der dielektrisch behinderten Entladung befindet sich zwischen den beiden Polen einer Hochspannung mindestens ein Dielektrikum 1. Das Dielektrikum 1 ist bei der Vorrichtung gemäß Fig. 1 für elektromagnetische Strahlung transparent. Konkret ist das Dielektrikum 1 hier eine Glasplatte. Auf der .Rückseite des transparenten Dielektrikums ist eine Festkörperelektrode 2 angeordnet, die ebenfalls transparent ist. Dies ist dadurch realisiert, dass die Festkörperelektrode 2 eine elektrisch leitfähige, aber dennoch lichtdurchlässige Schicht oder ein an sich nicht transparentes Metallgitter ist, das eine Flächenbelegung von nur wenigen Prozent und damit eine Transmission für die elektromagnetische Strahlung von mehr als 90 % aufweist. Die Festkörperelektrode 2 ist an einen Spannungsgenerator 4 angeschlossen. Der andere, hier nicht dargestellte Pol des Spannungsgenerators 4 ist in der Regel elektrisch geerdet. Durch Anlegen einer Hochspannung in einem typischen Bereich von 2 bis 60 kV bei einer typischen Frequenz von 100 Hz bis 1 MHz mit dem Spannungsgenerator 4 an die Festkörperelektrode 2 wird zwischen der Festkörperelektrode 2 bzw. der hier nach unten zeigenden Vorderseite 3 des Dielektrikums 1 und einer Oberfläche 6 eines Körpers 7 eine Gasentladung 8 gezündet. Die Gasentladung 8 tritt quasihomogen über den gesamten Zwischenraum der Festkörperelektrode 2 bzw. des Dielektrikums 1 und der Oberfläche 6 auf, der in seiner Haupterstreckungsebene eine Fläche von mehreren 10 cm² überspannt. Ein durch die Gasentladung 8 generiertes Plasma weist reaktive Spezies auf, die auf die Oberfläche 6 einwirken. Dabei hängen diese Spezies von dem Gas ab, in dem die Gasentladung 8 hervorgerufen wird. Wenn die Gasentladung 8, was bevorzugt ist, bei Atmosphärendruck in Luft hervorgerufen wird, zählen zu diesen reaktiven Spezies Sauerstoffradikale, die zum Beispiel Bakterien an der Oberfläche 6 durch Oxidation abtöten können. Der Körper 7 kann sich auf Erdpotential befinden. Er kann zu diesem Zweck geerdet sein. Dies ist aber nicht zwingend erforderlich, weil er selbst bei einer unipolaren Wechselspannung an der Festkörperelektrode 2 durch die über die Gasentladung 8 fließenden Ströme aufgrund der dielektrischen Behinderung der Gasentladung 8 durch das Dielektrikum 1 allenfalls minimal aufgeladen wird. Gleichzeitig mit dem durch die Gasentladung 8 erzeugten Plasma, wirkt elektromagnetische Strahlung 9 von einer Strahlungsquelle 5 auf die Oberfläche 6 und die daran angrenzenden Bereiche des Körpers 7 ein. Die elektromagnetische Strahlung 9 kann im infraroten und/oder sichtbaren und/oder UV-Bereich liegen. Die gleichzeitige Einwirkung des durch die Gasentladung 8 erzeugten Plasmas und der elektromagnetischen Strahlung 9 auf die Oberfläche 6 ruft Synergieeffekte hervor, beispielsweise selektive Reaktionen der Oberfläche 6 mit reaktiven Spezies aus dem Plasma. Dabei kann die Behandlung der Oberfläche 6 sehr sanft erfolgen, ohne dass sie deshalb eine sehr lange Zeit in Anspruch nehmen muss, weil aufgrund der flächigen Ausdehnung der Festkörperelektrode 2 ein relativ großer Bereich der Oberfläche 6 auf einmal behandelt wird. Gleichzeitig erfolgt die Behandlung über die Querschnittsfläche der Gasentladung 8 gesehen sehr gleichmäßig.

### BEZUGSZEICHENLISTE

- 1: Dielektrikum
- 2: Festkörperelektrode
- 3: Vorderseite
- 4: Spannungsgenerator
- 5: Strahlungsquelle
- 6: Oberfläche
- 7: Körper
- 8: Gasentladung
- 9: elektromagnetische Strahlung

## Patentansprüche

1. Verfahren zur Behandlung einer Oberfläche (6) und/oder von einer Oberfläche (6) nahen Bereichen eines Körpers (7), wobei eine Spannung an eine mit Abstand zu der Oberfläche (6) angeordnete Festkörperelektrode (2) angelegt wird, um eine Gasentladung (8) zwischen der Oberfläche (6) und der Festkörperelektrode (2) hervorzurufen, und wobei im Bereich der Gasentladung (8) eine elektromagnetische Strahlung (9) von einer außerhalb der Gasentladung (8) angeordneten und autonom steuerbaren Strahlungsquelle (5) durch die für elektromagnetische Strahlung (9) transparente Festkörperelektrode (2) hindurch auf die Oberfläche (6) gerichtet wird, wobei die Festkörperelektrode (2) planar ist und parallel zu der Oberfläche (6) ausgerichtet wird,
**dadurch gekennzeichnet, dass**
die Gasentladung (8) durch ein vor der Festkörperelektrode (2) angeordnetes planares und für elektromagnetische Strahlung (9) transparentes Dielektrikum (1) als Barriereentladung ausgeführt wird, wobei die Festkörperelektrode (2) als elektrisch leitfähige, aber dennoch lichtdurchlässige Schicht oder als an sich für elektromagnetische Strahlung (9) nicht transparentes, Maschen aufweisendes Metallgitter auf der Rückseite des Dielektrikums angeordnet ist.

2. Verfahren nach Anspruch 1, **dadurch gekennzeichnet, dass** die Fläche der planaren Festkörperelektrode (2) mehrere cm², vorzugsweise mehrere 10 cm² und am meisten bevorzugt mindestens 100 cm² groß ist.

3. Verfahren nach Anspruch 1 oder 2, **dadurch gekennzeichnet, dass** die Spannung aus untereinander beabstandeten Spannungspulsen oder Spannungspulsgruppen ausgebildet wird, die vorzugsweise wechselnde Polaritäten aufweisen.

4. Verfahren nach einem der Ansprüche 1 bis 3, **dadurch gekennzeichnet, dass** die Gasentladung (8) bei Atmosphärendruck hervorgerufen wird.

5. Verfahren nach einem der Ansprüche 1 bis 4, **dadurch gekennzeichnet, dass** die Oberfläche (6) mit einem an die Festkörperelektrode (2) angeschlossenen Spannungsgenerator (4), der die an die Festkörperelektrode (2) angelegte Spannung generiert, nicht elektrisch kontaktiert wird.

6. Verfahren nach einem der Ansprüche 1 bis 5, **dadurch gekennzeichnet, dass** die elektromagnetische Strahlung (9) aus infrarotem, sichtbarem oder ultraviolettem Licht ausgebildet wird.

7. Anwendung des Verfahrens nach einem der Ansprüche 1 bis 6 zur Aushärtung von Farben, Lacken oder anderen polymeren Oberflächenbeschichtungen.

8. Vorrichtung zur Behandlung einer Oberfläche (6) und/oder von einer Oberfläche (6) nahen Bereichen eines Körpers (7), mit einer mit Abstand zu der Oberfläche (6) anzuordnenden Festkörperelektrode (2), mit einem an die Festkörperelektrode (2) angeschlossenen Spannungsgenerator (4), um mit einer an die Festkörperelektrode (2) angelegten Spannung eine Gasentladung (8) zwischen der Oberfläche (6) und der Festkörperelektrode (2) hervorzurufen, und mit einer außerhalb der Gasentladung (8), hinter der Festkörperelektrode (2) angeordneten Strahlungsquelle (5), um im Bereich der Gasentladung (8) eine elektromagnetische Strahlung (9) durch die für elektromagnetische Strahlung (9) transparente Festkörperelektrode (2) hindurch auf die Oberfläche (6) zu richten, wobei die Festkörperelektrode (2) planar ist und parallel zu der Oberfläche (6) ausgerichtet wird,
**dadurch gekennzeichnet, dass**
vor der Festkörperelektrode (2) ein planares und für elektromagnetische Strahlung (9) transparentes Dielektrikum (1) angeordnet ist, um die Gasentladung (8) als Barriereentladung auszuführen, wobei die Festkörperelektrode (2) auf der Rückseite des Dielektrikums (1) als elektrisch leitfähige, aber dennoch lichtdurchlässige Schicht oder als an sich nicht für elektromagnetische Strahlung (9) transparentes, Maschen aufweisendes Metallgitter angeordnet ist.

9. Vorrichtung nach Anspruch 8, **dadurch gekennzeichnet, dass** die Fläche der planaren Festkörperelektrode (2) mehrere cm², vorzugsweise mehrere 10 cm² und am meisten bevorzugt mindestens 100 cm² groß ist.

10. Vorrichtung nach Anspruch 8 oder 9, **dadurch gekennzeichnet, dass** der Spannungsgenerator (4) die Spannung aus untereinander beabstandeten Spannungspulsen oder Spannungspulsgruppen ausbildet, die vorzugsweise wechselnde Polaritäten aufweisen.

11. Vorrichtung nach einem der Ansprüche 8 bis 10, **dadurch gekennzeichnet, dass** der Spannungsgenerator (4) keinen Kontakt zur elektrischen Kontaktierung der Oberfläche (6) aufweist.

12. Vorrichtung nach einem der Ansprüche 8 bis 11, **dadurch gekennzeichnet, dass** die Strahlungsquelle (5) infrarotes, sichtbares oder ultraviolettes Licht abstrahlt.

13. Vorrichtung nach einem der Ansprüche 8 bis 12, wobei die Festkörperelektrode (2) ein als solches nicht transparentes flächiges Metallgitter aufweist, **dadurch gekennzeichnet, dass** Maschen des Metallgitters eine Fläche von mehr als 0,2 mm², vorzugsweise mehr als 1 mm² und am meisten bevorzugt mehr als 5 mm² aufweisen und das das Metallgitter eine Flächenbelegung von weniger als 25 %, vorzugsweise weniger als 10 % und am meisten bevorzugt weniger als 5 % aufweist.

14. Aushärtevorrichtung für Farben, Lacke oder andere polymere Oberflächenbeschichtungen nach einem der Ansprüche 8 bis 13.

15. Haut- oder Wundtherapievorrichtung nach einem der Ansprüche 8 bis 13.

## Claims

1. Method of treating a surface (6) and/or areas of a body (7) that are close to a surface (6), wherein a voltage is applied to a solid body electrode (2) arranged at a distance to the surface (6) to generate a gas discharge (8) between the surface (6) and the solid body electrode (2), and wherein, in the area of the gas discharge (8), an electromagnetic radiation (9) from an independently controllable radiation source (5) arranged outside the gas discharge (8) is directed through the solid body electrode (2) which is transparent for the electromagnetic radiation (9) onto the surface (6), wherein the solid body electrode (2) is planar and arranged in parallel to the surface (6),
**characterised in that**
the gas discharge (8) is executed as a barrier discharge due to a planar dielectric (1) transparent for electromagnetic radiation (9) and arranged in front of the solid body electrode (2), wherein the solid body electrode (2) is arranged at the backside of the dielectric as an electrically conductive but light-transmissive layer or as a metal grid not being transparent as such but comprising open meshes.

2. Method of claim 1, **characterised in that** the surface area of the planar solid body electrode (2) is several cm², preferably several 10 cm² and most preferably at least 100 cm².

3. Method of claim 1 or 2, **characterised in that** the voltage is made of voltage pulses or voltage pulse groups following each other at distances, which voltage pulses or voltage pulse groups preferably comprise alternating polarities.

4. Method of any of the claims 1 to 3, **characterised in that** the gas discharge (8) is generated at atmospheric pressure.

5. Method of any of the claims 1 to 4, **characterised in that** the surface (6) is not electrically contacted to a voltage generator (4) connected to the solid body electrode (2) and generating the voltage applied to the solid body electrode (2).

6. Method of any of the claims 1 to 5, **characterised in that** the electromagnetic radiation (9) is made of infrared, visible or ultraviolet light.

7. Use of the method of any of the claims 1 to 6 for curing paints, varnishes and other polymeric surface coatings.

8. Apparatus for treating a surface (6) and/or areas of a body (7) that are close to a surface (6), comprising a solid body electrode (2) to be arranged at a distance to the surface (6), a voltage generator (4) connected to the solid body electrode (2) to generate a gas discharge (8) between the surface (6) and the solid body electrode (2) by means of a voltage applied to the solid body electrode (2), and a radiation source (5) arranged outside the gas discharge (8) behind the solid body electrode (2) to direct, in the area of the gas discharge (8), an electromagnetic radiation (9) through the solid body electrode (2) transparent for the electromagnetic radiation (9) onto the surface (6), wherein the solid body electrode (2) is planar and arranged in parallel to the surface (6),
**characterised in that**
a planar dielectric (1) transparent for electromagnetic radiation (9) is arranged in front of the solid body electrode (2) to execute the gas discharge (8) as a barrier discharge, wherein the solid body electrode (2) is arranged at the backside of the dielectric (1) as an electrically conductive but nevertheless light-transmissive layer or as a metal grid which is not transparent for electromagnetic radiation (9) as such but comprises open meshes.

9. Apparatus of claim 8, **characterised in that** the surface of the planar solid body electrode (2) is several cm², preferably several 10 cm² and most preferably at least 100 cm².

10. Apparatus of claim 8 or 9, **characterised in that** the voltage generator (4) makes the voltage of voltage pulses or voltage pulse groups arranged at distances, which voltage pulses or voltage pulse groups preferably comprise alternating polarities.

11. Apparatus of any of the claims 8 to 10, **characterised in that** the voltage generator (4) has no contactor for electrically contacting the surface (6).

12. Apparatus of any of the claims 8 to 11, **characterised in that** the radiation source (5) radiates infrared, visible or ultraviolet light.

13. Apparatus of any of the claims 8 to 12, wherein the solid body electrode (2) comprises a two-dimensional metal grid which is not transparent as such, **characterised in that** the open meshes of the metal grid have areas of more than 0.2 mm², preferably more than 1 mm² and most preferably more than 5 mm², and that the metal grid has an area occupancy of less than 25 %, preferably less than 10 % and most preferably less than 5 %.

14. Curing apparatus for paints, varnishes and other polymeric surface coatings of any of the claims 8 to 13.

15. Skin or wound therapy apparatus of any of the claims 8 to 13.

## Revendications

1. Procédé pour le traitement d'une surface (6) et/ou de zones d'un corps (7) proches d'une surface (6), une tension étant appliquée à une électrode solide (2) disposée à distance de la surface (6), afin de générer une décharge gazeuse (8) entre la surface (6) et l'électrode solide (2), et un rayonnement électromagnétique (9) provenant d'une source de rayonnement (5), disposée en dehors de la décharge gazeuse (8) et pouvant être commandée de manière autonome, étant dirigé, dans la zone de la décharge gazeuse (8), sur la surface (6) en passant au travers de l'électrode solide (2) transparente pour le rayonnement électromagnétique (9), ladite électrode solide (2) étant plane et orientée parallèlement à la surface (6),
**caractérisé en ce que**
la décharge gazeuse (8) est réalisée sous forme de décharge barrière par un diélectrique (1) plan disposé devant l'électrode solide (2) et transparent pour le rayonnement électromagnétique (9), ladite électrode solide (2) étant disposée sur la face arrière du diélectrique sous la forme d'une couche électroconductrice, mais laissant passer la lumière, ou sous la forme d'une grille métallique non transparente en soi pour le rayonnement électromagnétique (9) et comportant des mailles.

2. Procédé selon la revendication 1, **caractérisé en ce que** la surface de l'électrode solide (2) mesure plusieurs cm², de préférence plusieurs 10 cm² et encore mieux au moins 100 cm².

3. Procédé selon la revendication 1 ou 2, **caractérisé en ce que** la tension est constituée d'impulsions de tension ou de groupes d'impulsions de tension, qui sont situés à distance les uns des autres et qui, de préférence, présentent des polarités variables.

4. Procédé selon l'une quelconque des revendications 1 à 3, **caractérisé en ce que** la décharge gazeuse (8) est générée sous la pression atmosphérique.

5. Procédé selon l'une quelconque des revendications 1 à 4, **caractérisé en ce que** la surface (6) n'est pas mise en contact électrique avec un générateur de tension (4), qui est raccordé à l'électrode solide (2) et qui génère la tension appliquée à l'électrode solide (2).

6. Procédé selon l'une quelconque des revendications 1 à 5, **caractérisé en ce que** le rayonnement électromagnétique (9) est constitué de lumière infrarouge, visible ou ultraviolette.

7. Utilisation du procédé selon l'une quelconque des revendications 1 à 6 pour le durcissement de peintures, vernis ou autres revêtements de surface polymères.

8. Dispositif pour le traitement d'une surface (6) et/ou de zones d'un corps (7) proches d'une surface (6), comportant une électrode solide (2) à disposer à distance de la surface (6), comportant un générateur de tension (4) raccordé à l'électrode solide (2) afin de générer, au moyen d'une tension appliquée à l'électrode solide (2), une décharge gazeuse (8) entre la surface (6) et l'électrode solide (2), et comportant une source de rayonnement (5), disposée en dehors de la décharge gazeuse (8) derrière l'électrode solide (2) afin de diriger, dans la zone de la décharge gazeuse (8), un rayonnement électromagnétique (9) sur la surface (6) en passant au travers de l'électrode solide (2) transparente pour le rayonnement électromagnétique (9), ladite électrode solide (2) étant plane et orientée parallèlement à la surface (6),
**caractérisé en ce**
**qu'**un diélectrique (1) plan et transparent pour le rayonnement électromagnétique (9) est disposé devant l'électrode solide (2) pour générer la décharge gazeuse (8) sous forme de décharge barrière, ladite électrode solide (2) étant disposée sur la face arrière du diélectrique (1) sous la forme d'une couche électroconductrice, mais laissant passer la lumière, ou sous la forme d'une grille métallique non transparente en soi pour le rayonnement électromagnétique (9) et comportant des mailles.

9. Dispositif selon la revendication 8, **caractérisé en ce que** la surface de l'électrode solide (2) plane mesure plusieurs cm², de préférence plusieurs 10 cm² et encore mieux au moins 100 cm².

10. Dispositif selon la revendication 8 ou 9, **caractérisé en ce que** le générateur de tension (4) génère une tension sous forme d'impulsions de tension ou de groupes d'impulsions de tension, qui sont situés à distance les uns des autres et qui, de préférence, présentent des polarités variables.

11. Dispositif selon l'une quelconque des revendications 8 à 10, **caractérisé en ce que** le générateur de tension (4) ne présente pas de contact pour la mise en contact électrique de la surface (6).

12. Dispositif selon l'une quelconque des revendications 8 à 11, **caractérisé en ce que** la source de rayonnement (5) émet une lumière infrarouge, visible ou ultraviolette.

13. Dispositif selon l'une quelconque des revendications 8 à 12, dans lequel l'électrode solide (2) comporte une grille métallique plane, non transparente en soi, **caractérisé en ce que** les mailles de la grille métallique ont une surface de plus de 0,2 mm², de préférence de plus de 1 mm² et, encore mieux, de plus de 5 mm², et **en ce que** la grille métallique occupe une surface inférieure à 25 %, de préférence inférieure à 10 % et, encore mieux, inférieure à 5 %.

14. Dispositif de durcissement pour des peintures, vernis ou autres revêtements de surface polymères selon l'une quelconque des revendications 8 à 13.

15. Dispositif thérapeutique pour le traitement de la peau ou des plaies selon l'une quelconque des revendications 8 à 13.
